# EUROPEAN PATENT SPECIFICATION

(11) **EP 2 371 536 B1**
(45) Date of publication and mention of the grant of the patent: **24.10.2018**
(21) Application number: 09834755.2
(22) Date of filing: 10.12.2009
(51) Int. Cl.: B32B 15/088, H05K 1/09, H05K 3/38

(54) **COPPER FOIL WITH RESIN**
KUPFERFOLIE MIT HARZ
FEUILLE DE CUIVRE COMPRENANT UNE RÉSINE

(30) Priority: 26.12.2008 JP 2008334408
(43) Date of publication of application: 05.10.2011
(73) Proprietor: Mitsubishi Gas Chemical Company, Inc., Tokyo 100-8324 (JP); PI R & D Co. Ltd, Yokohama-shi Kanagawa 236-0002 (JP)
(72) Inventor: NOZAKI, Mitsuru, Tokyo 125-8601 (JP); OOMORI, Takabumi, Tokyo 125-8601 (JP); NOMOTO, Akihiro, Tokyo 125-8601 (JP); AKIYAMA, Norikatsu, Tokyo 125-8601 (JP); NAGATA, Eiji, Yokohama-shi Kanagawa 236-0002 (JP); YANO, Masashi, Yokohama-shi Kanagawa 236-0002 (JP)
(74) Representative: Murgitroyd & Company
(86) International application number: PCT/JP2009/071005
(87) International publication number: WO 2010/073952

(56) References cited:
- WO-A1-2007/015545
- JP-A- 2000 052 483
- JP-A- 2002 356 563
- JP-A- 2003 119 285
- JP-A- 2006 082 228
- JP-A- 2007 253 366
- JP-A- 2007 277 334
- JP-A- 2008 207 550
- JP-A- 2008 254 352
- US-A1- 2006 054 589
- US-A1- 2007 148 421
- US-A1- 2007 172 674
- US-A1- 2008 200 084

## Description

### TECHNICAL FIELD

This invention relates to a resin composite copper foil used in a printed wiring board. A resin composite copper foil obtained in the invention is excellent in the adhesion force to a resin composition of a copper-clad laminate, and a copper-clad laminate using such a foil is good in the heat resistance and is preferably used as a high density printed wiring board with fine circuits because it is possible to use a copper foil with very small unevenness on a copper foil (matte) surface.

### RELATED ART

Recently, a demand for high densification of printed wiring boards is increasing in small-size, thin and lightweight electronic devices, and it is required to improve the formation of fine circuits in a copper foil used in association therewith. Heretofore, as a copper foil of a copper-clad laminate used in the printed wiring board is used an electrolytic copper foil having a good copper foil adhesion force and remarkable unevenness on a copper foil matte surface. These electrolytic copper foils are good in the adhesion force, but have problems that when the fine circuits are formed by etching process, a part of convex portions in the copper foil is liable to remain on a resin surface of the laminate due to the influence of unevenness on the copper foil matte surface and that if an etching time is extended in order to completely remove the remaining part, the circuits are over-etched to deteriorate location accuracy of the circuit and adhesion force. A so-called low profile copper foil with suppressed unevenness on the copper foil matte surface is put into practical use as means for improving them. However, when this copper foil is applied to a copper-clad laminate together with a high heat-resistant thermosetting resin having essentially a weak adhesion force or the like, deficiency in the adhesion force becomes a problem in the fine circuit, which is an obstacle in the progress of high densification. Also, a copper-clad laminate using a copper foil formed with a thin adhesive layer (e.g., see Patent Document 1) and a copper-clad laminate using a copper foil provided with a semi-hardened resin film (e.g., see Patent Document 2) are proposed as an example of using a copper foil with an adhesive. In these copper-clad laminates, there are problems in the adhesion force level and heat resistance under moisture absorption, and further improvements are required. Moreover, a resin composite copper foil having a block copolymerized polyimide resin layer formed (e.g., see Patent Document 3) is proposed in order to solve these problems. However, when a copper-clad laminate using such a resin composite copper foil is subjected to blind via-hole processing, through-hole processing, blind through-hole processing and the like by carbon dioxide gas laser, the processability of the block copolymerized polyimide resin layer is poor and burrs of the through-hole and the blind via-hole by the carbon dioxide gas layer laser become large, so that there is a problem in the connection reliability.
Patent Document 4 relates to a resin composite copper foil comprising a copper foil and a polyimide resin layer formed on one surface of the copper foil. However, this document does not disclosure the use of an inorganic filler. Patent Document 5 describes the use of an inorganic filler in a polyamide resin bonding layer of a resin composite copper foil. However, the polyimide resin is different to that of the present invention.

### PRIOR ART DOCUMENTS

### PATENT DOCUMENTS

Patent Document 1: JP-A-H08-216340
Patent Document 2: JP-A-H09-011397
Patent Document 3: JP-A-2006-082228
Patent Document 4: US 2006/054589 A1
Patent Document 5: US 2007/148421 A1

### SUMMARY OF THE INVENTION

### PROBLEM TO BE SOLVED BY THE INVENTION

It is an object of the invention to provide a resin composite copper foil capable of applying a copper foil with very small unevenness on a copper foil (matte) surface without deteriorating adhesion force to a resin composition of a copper-clad laminate as well as a copper-clad laminate and a printed wiring board using this resin composite copper foil and having good heat resistance and heat resistance under moisture absorption, and to provide a material being excellent in the processability by carbon dioxide gas laser.

### MEANS FOR SOLVING PROBLEM

The inventors have made various studies in order to solve the above problems and found that a copper-clad laminate having an excellent heat resistance, small burrs when subjected to blind via-hole processing, through-hole processing, blind through-hole processing and the like by carbon dioxide gas laser and an excellent connection reliability is obtained by using a resin composite copper foil obtained by forming a polyimide resin layer containing a specific block copolymerized polyimide resin and an inorganic filler on one surface of the copper foil, and as a result, the invention has been accomplished. More specifically, the invention is as follows.
[1] A resin composite copper foil comprising a copper foil and a polyimide resin layer formed on one surface of the copper foil,
   wherein the polyimide resin layer comprises a block copolymerized polyimide resin and an inorganic filler, and
   the block copolymerized polyimide resin has a structure formed by alternately repeating a structure A and a structure B,
   wherein the structure A is obtained by bonding a second imide oligomer to a terminal of a first imide oligomer and the structure B is obtained by bonding the first imide oligomer to a terminal of the second imide oligomer, and
   the block copolymerized polyimide resin is a block copolymer comprising the first imide oligomer represented by the following general formula (1) and the second imide oligomer represented by the following general formula (2): 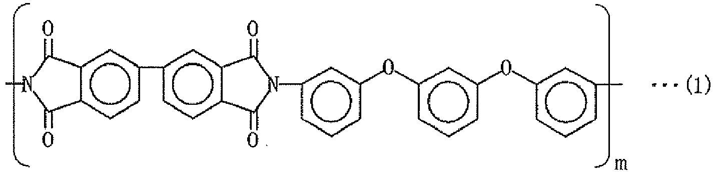 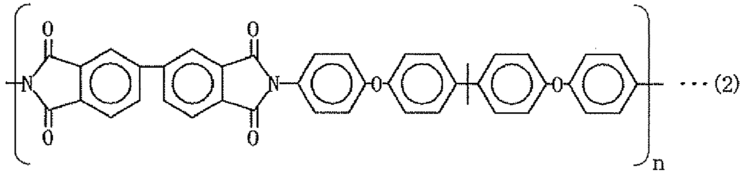 wherein m and n are integers meeting m:n=1:9 to 3:1).
[2] A resin composite copper foil according to item [1], wherein an amount of the inorganic filler contained in the polyimide resin layer is not less than 5% by volume but not more than 50% by volume based on 100% by volume in total of the block copolymerized polyimide resin and the inorganic filler, and a weight average molecular weight of the first imide oligomer is 5,000 to 30,000.
[3] A resin composite copper foil according to any one of items [1] to [2], wherein the polyimide resin layer includes a maleimide compound.
[4] A resin composite copper foil according to any one of items [1] to [3], wherein the polyimide resin layer has a thickness of 1 µm to 10 µm.
[5] A resin composite copper foil according to any one of items [1] to [4], wherein the copper foil has a surface roughness (Rz) of not more than 4 µm on a surface of forming the polyimide resin layer.
[6] A copper-clad laminate formed by laminating a resin composite copper foil as described in any one of items [1] to [5] and a B-stage resin composition layer.
[7] A printed wiring board using a resin composite copper foil as described in any one of items [1] to [5].
[8] A printed wiring board using a copper clad laminate according to item [6].
[9] A copper clad laminate according to item [6], wherein the B-stage resin composition layer contains a resin and an inorganic filler, and an amount of the inorganic filler contained is not less than 5% by volume but not more than 50% by volume based on 100% by volume in total of the resin and the inorganic filler.
[10] A printed wiring board according to item [8], wherein the B-stage resin composition layer contains a resin and an inorganic filler, and an amount of the inorganic filler contained is not less than 5% by volume but not more than 50% by volume based on 100% by volume in total of the resin and the inorganic filler. --

### EFFECT OF THE INVENTION

The resin composite copper foil obtained in the invention is possible to use a copper foil with very small unevenness on a copper foil (matte) surface without deteriorating adhesion force to a resin composition of a copper-clad laminate, and by using this resin composite copper foil is obtained a copper-clad laminate being good in the heat resistance and heat resistance under moisture absorption and excellent in the processability for through-hole, blind via-hole and the like by carbon dioxide gas laser. Also, the copper-clad laminate is preferably used as a high density printed wiring board with fine circuits, so that the industrial practicality of the resin composite copper foil according to the invention is extremely high.

### BRIEF DESCRIPTION OF THE DRAWING

The invention will be described with reference to the accompanying drawing, wherein:

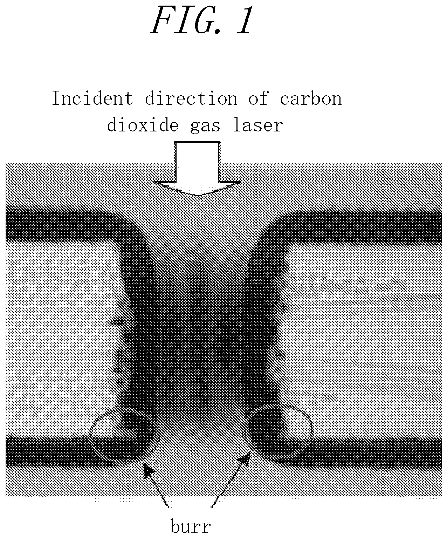

FIG. 1 is a photograph in cross section of a plated through-hole.

### MODE FOR CARRYING OUT THE INVENTION

A block copolymerized polyimide resin used in a resin composite copper foil of the invention is a block copolymer having a structure as defined in the claims formed by alternately repeating a structure A of bonding a second imide oligomer to a terminal of a first imide oligomer and a structure B of bonding the first imide oligomer to a terminal of the second imide oligomer. Moreover, the second imide oligomer is different from the first imide oligomer in the structural unit. These block copolymerized polyimide resins are synthesized by a sequential polymerization reaction wherein a tetracarboxylic dianhydride and a diamine are reacted in a polar solvent to form an imide oligomer and thereafter the tetracarboxylic dianhydride and another diamine, or another tetracarboxylic dianhydride and the diamine are further added to conduct imidization. As the first imide oligomer, it is desirable to use an imide oligomer having a weight average molecular weight of about 5,000 to 30,000. The tetracarboxylic dianhydride to be used includes 3,4,3',4'-biphenyl tetracarboxylic dianhydride and the like, **and the diamine includes** 1,3-bis(3-aminophenoxy)benzene, 2,2-bis[4-(4-aminophenoxy)phenyl]propane and the like. As the polar solvent to be used are mentioned polar solvents dissolving a polyimide, such as N-methyl-2-pyrrolidone, dimethylacetamide, dimethylformamide, dimethyl sulfoxide, sulfolane, tetramethylurea and so on. Also, it is possible to be used by mixing with a ketone- or ether-based solvent. As the ketone-based solvent can be used methyl ethyl ketone, methyl propyl ketone, methyl isopropyl ketone, methyl butyl ketone, methyl isobutyl ketone, methyl-n-hexyl ketone, diethyl ketone, diisopropyl ketone, diisobutyl ketone, cyclopentanone, cyclohexanone, methylcyclohexanone, acetylacetone, diacetone alcohol and cyclohexene-n-one. As the ether-based solvent can be used dipropyl ether, diisopropyl ether, dibutyl ether, tetrahydrofuran, tetrahydropyran, ethyl isoamyl alcohol, ethyl-t-butyl ether, ethyl benzyl ether, diethylene glycol dimethyl ether, cresyl methyl ether, anisole and phenetole. In order to remove water produced upon imidization reaction, it is required to add a solvent azeotroping with water such as toluene, xylene or the like to remove water out of the system. Moreover, in order to promote the reaction, an amine-based catalyst such as pyridine or the like, or a two-component catalyst of a base such as such as pyridine, γ-valerolactone or the like and a cyclic ester is preferably used. The reaction temperature is 120 to 200°C. It is possible to obtain a solution of only the block copolymerized polyimide resin in the polar solvent by eventually distilling the solvent azeotroping with water such as toluene, xylene or the like and the catalyst such as pyridine or the like out of the system.

As the block copolymerized polyimide resin used in the invention is preferable a block copolymer comprising the first imide oligomer represented by the above general formula (1) and the second imide oligomer represented by the above general formula (2). The tetracarboxylic dianhydride used in the block copolymerized polyimide resin is 3,4,3',4'-biphenyl tetracarboxylic dianhydride and the diamine is 1,3-bis(3-aminophenoxy)benzene and 2,2-bis[4-(4-aminophenoxy)phenyl]propane. Also, in order to control the molecular weight of each unit polycondensate, the molar ratio of the tetracarboxylic dianhydride to the diamine at the first stage reaction is shifted to render the terminal into an acid anhydride or an amine and the molar ratio of the tetracarboxylic dianhydride to another diamine or another tetracarboxylic dianhydride to the diamine in the second stage reaction is made reverse to that of the first stage, whereby it is possible to obtain a block copolymerized polyimide with a sufficient molecular weight. The weight average molecular weight (Mw) of the block copolymerized polyimide resin used in the invention is desirably 50,000 to 300,000, and more preferably 80,000 to 200,000. When Mw is less than 50,000, the polyimide resin layer becomes brittle and cannot be used for the object of the invention. While, when Mw exceeds 300,000, the viscosity of the solution becomes too high and coating becomes difficult. In order to control the final molecular weight, it is also possible to synthesize the resin by shifting the molar ratio of the tetracarboxylic dianhydride and the diamine to be used. The molar ratio of each unit polycondensate of the general formula (1) and the general formula (2) is preferably general formula (1): general formula (2) = 1: 9 to 3: 1, more preferably general formula (1): general formula (2) = 1: 3 to 3: 1. When the ratio of the structure of the general formula (1) becomes less than 10 mol%, the deterioration of the adhesion force becomes a problem, and when the ratio of the structure of the general formula (2) becomes less than 25 mol%, the deterioration of the solder heat resistance becomes a problem.

The inorganic filler contained in the polyimide resin layer of the resin composite copper foil according to the invention is not particularly limited as long as it is generally used, but includes concretely silicas such as natural silica, fused silica, amorphous silica, hollow silica and the like; metal hydrates such as aluminum hydroxide, a heat treated product of aluminum hydroxide (wherein aluminum hydroxide is subjected to a heat treatment to reduce a part of crystal water), boehmite, magnesium hydroxide and the like; molybdenum compounds such as molybdenum oxide, zinc molybdate and the like; titanium oxide, barium titanate, barium sulfate, zinc borate, zinc stannate, alumina, clay, kaolin, talc, calcined clay, calcined kaoline, calcined talc, mica, glass short fibers (fine glass powders such as E-glass and D-glass), hollow glass, whisker and so on. Preferably, the above-mentioned silicas, metal hydrates such as aluminum hydroxide, a heat treated product of aluminum hydroxide (wherein aluminum hydroxide is subjected to a heat treatment to reduce a part of crystal water), boehmite, and magnesium hydroxide, talc, calcined talc and so on are used. They are used alone or in combination of two or more properly. The amount of the inorganic filler contained is not particularly limited, but is preferably not less than 5 % by volume but not more than 50 % by volume, more preferably not less than 19 % by volume but not more than 40 % by volume, further more preferably not less than 19 % by volume but not more than 30 % by volume based on 100 % by volume in total of the block copolymerized polyimide resin and the inorganic filler from a viewpoint of the processability through carbon dioxide gas laser. Also, in order to uniformly disperse the inorganic filler into the block copolymerized polyimide resin, it is preferable to use various dispersants. Moreover, in order to enhance adhesion between the inorganic filler and the block copolymerized polyimide resin, it is effective to treat the inorganic filler with a coupling agent such as a silane coupling agent or the like or to add a proper amount of the coupling agent to the resin. The average particle size of the inorganic filler is preferably not more than 4 µm, more preferably not more than 1 µm in view of the uniformity of the block copolymerized polyimide resin layer.

The polyimide resin layer in the resin composite copper foil of the invention preferably includes a maleimide compound. The maleimide compound is not particularly limited as long as it is a compound having two or more maleimide groups in one molecule. As the maleimide compound are preferably mentioned bis(4-maleimidephenyl)methane, polyphenylmethane maleimide, m-phenylene bismaleimide, bisphenol A diphenyl ether bismaleimide(2,2'-bis[4-(4-maleimidephenoxy)phenyl]propane), 3,3'-dimethyl-5,5'-diethyl-4,4'-diphenylmethane bismaleimide, 4-methyl-1,3-phenylene bismaleimide. Bisphenol A diphenyl ether bismaleimide(2,2'-bis[4-(4-maleimidephenoxy)phenyl]propane) is more preferable. The maleimide compounds may be used alone or in a combination of two or more properly. Moreover, it is also possible to use a prepolymer of the maleimide compound, or a prepolymer of the maleimide compound with an amine compound. The ratio of the block copolymerized polyimide to the maleimide compound contained in the resin layer of the resin composite copper foil is preferably in the range of 1: 9 to 9: 1 as a weight ratio.

The copper foil used in the resin composite copper foil of the invention is not particularly limited as long as it is a well-known copper foil used in the printed wiring board, but an electrolytic copper foil, a rolled copper foil, a copper alloy thereof and the like are preferably used. Also, these copper foils may be subjected to a well-known surface treatment such as treatment with nickel, treatment with cobalt or the like. The thickness of the copper foil is not particularly limited, but is preferably not more than 35 µm, more preferably 5 µm to 12 µm. Further, the surface roughness (Rz) of the copper foil surface forming the polyimide resin layer is preferably not more than 4 µm, more preferably not more than 2 µm. Here, Rz is a 10-point average roughness defined according to JIS B 0601.

The thickness of the polyimide resin layer in the resin composite copper foil of the invention can be adjusted depending upon the surface roughness level of the copper foil. However, as it becomes thicker, drying in the heating step after the coating of the copper foil is liable to be insufficient and the heat resistance of the copper-clad laminate used may be deteriorated. Therefore, it is preferably 1 µm to 10 µm, more preferably 1 µm to 7 µm.

The resin composite copper foil of the invention can be prepared by adding a maleimide compound if needed to a polar solvent solution of the block copolymerized polyimide resin obtained, for example, in the above synthesis method with stirring, dispersing an inorganic filler thereinto by a well-known method, directly applying it onto one surface of a copper foil and then drying it. As the application system may be used various systems such as reverse roll, rod (bar), blade, knife, die, gravure, rotary screen and the like. For drying, a hot air drying machine, an infrared ray dryer and the like can be used, but not particularly limited thereto, as long as they can heat up to a temperature enough to remove the solvent used. Moreover, in order to prevent oxidation of the copper foil, it is also possible to dry the foil below 200°C for a long time or to dry it at a further higher temperature under vacuum or in an inert atmosphere of nitrogen or the like.

The resin composition used in the B-stage resin composition layer to be laminated with the resin composite copper foil of the invention is not particularly limited as long as it is a well-known thermosetting resin composition used in the printed wiring board. These resins include, for example, an epoxy resin, a phenolic resin, a polyimide resin, a cyanate ester resin, a maleimide resin, a double bond-added polyphenylene ether resin, a resin composition containing each of these resins and a bromine- or phosphorus-containing compound and so on, and are used alone or in a combination of two or more. A resin composition having a cyanate ester resin as an essential component is preferable to be used, for example, together with an epoxy resin or the like in terms of reliability of migration resistance, heat resistance and the like. It is possible to use well-known catalyst, hardener, and hardening accelerator in these thermoset resins if needed.

The cyanate ester resin preferably used in the resin composition for use in the B-stage resin composition layer is a compound having two or more cyanato groups i its molecule. As a concrete example, there are 1,3- or 1,4-dicyanato benzene, 1,3,5-tricyanato benzene, 1,3-, 1,4-, 1,6-, 1,8-, 2,6- or 2,7-dicyanato naphthalene, 1,3,6-tricyanato naphthalene, 4,4-dicyanatobiphenyl, bis(4-dicyanatophenyl)methane, 2,2-bis(4-cyanatophenyl)propane, 2,2-bis(3,5-dibromo-4-cyanatophenyl)propane, bis(4-cyanatophenyl)ether, bis(4-cyanatophenyl)thioether, bis(4-cyanatophenyl)sulfone, tris(4-cyanatophenyl)phosphite, tris(4-cyanatophenyl)phosphate, cyanates obtained by reaction of novolac and halogenated cyanogen halide and so on.

Phenol novolac type cyanate ester compounds described in JP-B-S41-1928, JP-B-S43-18468, JP-B-S44-4791, JP-B-S45-11712, JP-B-S46-41112, JP-B-S47-26853 and JP-A-S51-63149, and naphthol aralkyl type cyanate ester compounds described in JP-A-2007-045968 are also used. Furthermore, a prepolymer with a molecular weight of 400 to 6,000 having a triazine ring formed by trimerization of the cyanato group of these cyanate ester compounds is used. This prepolymer is obtained by polymerization of the above cyanate ester monomer, for example, using an acid such as mineral acid, Lewis acid or the like; a base such as sodium alcolate, tertiary amine or the like; a salt such as sodium carbonate or the like as a catalyst. This resin includes partially an unreacted monomer and is in the form of a mixture of monomer and prepolymer. Such a starting material is preferably used in the application of the invention. Furthermore, a cyanated polyphenylene ether resin can be used. A monofunctional cyanate ester compound can also be added thereto in an amount which does not significantly affect the properties. It is preferably 1 to 10% by weight. These cyanate ester resins are not limited to the above, but the well-known ones can be used. They are used alone or in a combination of two or more properly.

As the epoxy resin used in the B-stage resin composition layer can be used well-known ones. Specifically, mention may be made of a bisphenol A type epoxy resin, a bisphenol F type epoxy resin, a phenol novolac type epoxy resin, a cresol novolac type epoxy resin, an alicyclic epoxy resin, a biphenyl type epoxy resin, a fluorene type epoxy resin, a resorcin type epoxy resin, a naphthalene type epoxy resin, a phenol aralkyl type epoxy resin, a biphenyl aralkyl type epoxy resin, an epoxidized polyphenylene ether resin; polyepoxy compounds obtained by epoxidizing double bonds in butadiene, pentadiene, vinyl cyclohexene, dicyclopentenyl ether or the like; polyols, a polyglycidyl compound obtained by the reaction of a hydroxyl group-containing silicone resin and epichlorohydrin, and so on. Also, it includes well-known bromine-added resins, phosphorous-containing epoxy resins and the like. They are used alone or in a combination of two or more properly.

As the phenolic resin used in the B-stage resin composition layer can be used well-known ones. Specifically, it includes a novolac type phenolic resin, a cresol type phenolic resin, an aryl alkylene type phenolic resin and so on. Also, it includes well-known bromine-added resins, phosphorous-containing resins and the like. They are used alone or in a combination of two or more properly.

The resin composition used in the B-stage resin composition layer may be compounded with various additives, if desired, within a scope of damaging no properties inherent to the composition. As the additive are exemplified polymerizable double bond-containing monomers such as unsaturated polyester and the like as well as prepolymers thereof; low molecular weight liquid to high molecular weight elastic rubbers such as polybutadiene, maleinated butadiene, a butadiene-acrylonitrile copolymer, polychloroprene, butadiene-styrene copolymer, polyisoprene, butyl rubber, fluororubber, natural rubber and so on; polyethylene, polypropylene, polybutene, poly-4-methylpentene, polystyrene, AS resin, ABS resin, MBS resin, styrene-isoprene rubber, acrylic rubber, core shell rubbers thereof, polyethylene-propylene copolymer, 4-fluorinated ethylene-6-fluorinated ethylene copolymer; high molecular weight prepolymers or oligomers such as polycarbonate, polyphenylene ether, polysulfone, polyester, polyphenylene sulfide and so on; polyurethane and the like, which are used properly. Also, other well-known additives such as organic filler, inorganic filler, dye, pigment, thickener, lubricant, defoamer, dispersant, leveling agent, photosensitizer, flame retardant, brightener, polymerization inhibitor, thixotropic agent and the like are used in a proper combination if desired. If needed, a hardener and a catalyst are properly compounded in a compound having a reactive group.

Particularly, when processing such as piercing is conducted by carbon dioxide gas laser, it is preferable to add an inorganic filler to the B-stage resin composition layer for obtaining a good hole shape. As the inorganic filler can be used the same inorganic filler as contained in the polyimide resin layer of the resin composite copper foil of the invention. Preferably, silica such as fused silica or the like, metal hydrates such as aluminum hydroxide, a heat treated product of aluminum hydroxide (wherein aluminum hydroxide is subjected to a heat treatment to reduce a part of crystal water), boehmite, and magnesium hydroxide; talc, calcinated talc and the like are used. They are used alone or in a combination of two or more properly. The amount of the inorganic filler contained is not particularly limited, but is preferably not less than 5% by volume but not more than 50% by volume, more preferably not less than 10% by volume but not more than 40% by volume, further more preferably not less than 15% by volume but not more than 30% by volume based on 100% by volume in total of the B-stage resin and the inorganic filler used in the B-stage resin composition layer in terms of processibility through carbon dioxide gas laser.

The B-stage resin composition layer used in the invention can be prepared by well-known methods, but not particularly limited to, such as a method wherein the thermosetting resin composition is dissolved or dispersed in a solvent or rendered into a varnish in the absence of a solvent and applied onto one surface of a releasing film and then dried to form a B-stage resin composition sheet, a method of applying to a substrate and drying to form a B-stage prepreg, a method of directly applying onto a substrate provided with conductor circuits and drying to form a B-stage resin composition layer, and so on. The thickness of the B-stage resin composition layer is not particularly limited, but is preferably 4 to 150 µm in case of a sheet likewise the applying case. Moreover, in case of a prepreg, the thickness is preferably 10 to 200 µm.

In the B-stage resin composition layer used in the invention, it is preferable to use a substrate in view of the properties of the resulting copper-clad laminate. The substrate to be used is not particularly limited as long as it is a well-known substrate used in the printed wiring board. Specifically, mention may be made of nonwoven fabrics, woven fabrics and the like of generally known glass fibers such as E-, NE-, D-, S-, and T-glasses. These substrates are preferable to be subjected to a well-known surface treatment for improving the adhesion to the resin composition.

The copper-clad laminate according to the invention is produced by a method wherein the resin layer surface of the resin composite copper foil is arranged opposing the B-stage resin composition layer and laminated thereon. Specifically, the copper-clad laminate is formed by arranging the resin layer surface of the resin composite copper foil opposing at least one surface of the B-stage resin composition layer or a laminated plate provided on both surfaces with the B-stage resin composition layers and then laminating them through heating and pressurizing, preferably under vacuum. Also, in case of preparing a multilayer board, the B-stage resin composition layers are arranged or formed on both surfaces of an innerlayer substrate having conductor circuits formed and the resin layer surface of the resin composite copper foil is arranged opposing the B-stage resin composition layer surface, and then they are laminated through heating and pressurizing, preferably under vacuum to form a multilayer copper-clad laminate. A printed wiring board is prepared by subjecting the copper-clad laminate or multilayer copper-clad laminate to a plating treatment or the like after the formation of conductor circuits by a well-known method.

The kinds of the laminated plate or circuit substrate used herein are not particularly limited, and well-known laminated plates and metal foil-clad boards, preferably a copper-clad board for the printed wiring board can be used. Specifically, there can be used well-known ones such as a copper-clad laminate of inorganic fiber and/or organic fiber substrate using thermosetting resin composition and/or thermoplastic resin composition, a copper-clad board of heat resistant film substrate, a copper-clad laminate of a composite substrate combining these substrates and a multilayer copper-clad board thereof, a multilayer copper-clad board prepared by an additive method or the like, and so on. The conductor thickness of the circuit substrate is not particularly limited, but is preferably 3 to 35 µm. The conductor circuit is preferable to be subjected to a known treatment for enhancing the adhesion to the resin of the B-stage resin composition layer, such as black copper oxide treatment, liquid chemical treatment (CZ treatment of MEC for example) or the like.

The lamination conditions of the copper-clad laminate of the invention are not particularly limited, but the lamination is preferably conducted at a temperature of 100 to 250°C and a pressure of 5 to 40 kgf/cm² and a vacuum degree of not more than 30 mmHg for 30 minutes to 5 hours. Although the lamination may be conducted under these conditions from beginning to end, it is also possible to conduct the lamination up to gelation and subsequently conduct postcuring in a heating furnace.

### [Examples]

The invention will be described concretely in Examples and Comparative Examples below. It should be noted that "parts" means parts by weight in the solid content, unless otherwise specified.

### (Synthesis Example 1)

To a 2 L three-necked flask provided with an anchor shaped stirring stick of stainless steel and a reflux cooler equipped with a ball cooling tube mounted on a trap with a nitrogen introducing tube and a stopcock are added 117.68 g (400 mmol) of 3,4,3',4'-biphenyl tetracarboxylic dianhydride, 87.7 g (300 mmol) of 1,3-bis(3-aminophenoxy)benzene, 4.0 g (40 mmol) of γ-valerolactone, 4.8 g (60 mmol) of pyridine, 300g of N-methyl-2-pyrrolidone (hereinafter referred to as NMP) and 20 g of toluene, which are heated at 180°C for 1 hour and then cooled to about room temperature, and subsequently 29.42 g (100 mmol) of 3,4,3',4'-biphenyl tetracarboxylic dianhydride, 82.12 g (200 mmol) of 2,2-bis[4-(4-aminophenoxy)phenyl]propane, 200 g of NMP and 40 g of toluene are added and mixed at room temperature for 1 hour and then heated at 180°C for 3 hours to obtain a block copolymerized polyimide resin with a solid content of 38%. This block copolymerized polyimide resin has general formula (1): general formula (2) = 3: 2, a number average molecular weight of 70,000 and a weight average molecular weight of 150,000. Also, the weight average molecular weight of an imide oligomer block having a structural unit represented by the general formula (1) is 7,000. The solution of the block copolymerized polyimide resin is further diluted with NMP into a block copolymerized polyimide resin solution with a solid content of 15% to thereby obtain a block copolymerized polyimide A.

### (Synthesis Example 2)

To a 2 L three-necked flask provided with an anchor shaped stirring stick of stainless steel and a reflux cooler equipped with a ball cooling tube mounted on a trap with a nitrogen introducing tube and a stopcock are added 117.68 g (400 mmol) of 3,4,3',4'-biphenyl tetracarboxylic dianhydride, 123.18 g (300 mmol) of 2,2-bis[4-(4-aminophenoxy)phenyl]propane, 4.0 g (40 mmol) of γ-valerolactone, 4.8 g (60 mmol) of pyridine, 300g of NMP and 20 g of toluene, which are heated at 180°C for 1 hour and then cooled to about room temperature, and subsequently 29.42 g (100 mmol) of 3,4,3',4'-biphenyl tetracarboxylic dianhydride, 58.47 g (200 mmol) of 1,3-bis(3-aminophenoxy)benzene, 200 g of NMP and 40 g of toluene are added and mixed at room temperature for 1 hour and then heated at 180°C for 3 hours to obtain a block copolymerized polyimide resin with a solid content of 38%. This block copolymerized polyimide resin has general formula (1): general formula (2) = 2: 3, a number average molecular weight of 75,000, and a weight average molecular weight of 160,000. Also, the weight average molecular weight of an imide oligomer block having a structural unit represented by the general formula (2) is 8,000. The solution of the block copolymerized polyimide resin is further diluted with NMP into a block copolymerized polyimide resin solution with a solid content of 15% to thereby obtain a block copolymerized polyimide B.

### (Synthesis Example 3)

To a 2 L three-necked flask provided with an anchor shaped stirring stick of stainless steel and a reflux cooler equipped with a ball cooling tube mounted on a trap with a nitrogen introducing tube and a stopcock are added 117.68 g (400 mmol) of 3,4,3',4'-biphenyl tetracarboxylic dianhydride, 73.08 g (250 mmol) of 1,3-bis(3-aminophenoxy)benzene, 4.0 g (40 mmol) of γ-valerolactone, 4.8 g (60 mmol) of pyridine, 300g of N-methyl-2-pyrrolidone (hereinafter referred to as NMP) and 20 g of toluene, which are heated at 180°C for 1 hour and then cooled to about room temperature, and subsequently 29.42 g (100 mmol) of 3,4,3',4'-biphenyl tetracarboxylic dianhydride, 102.65 g (250 mmol) of 2,2-bis[4-(4-aminophenoxy)phenyl]propane, 200 g of NMP and 40 g of toluene are added and mixed at room temperature for 1 hour and then heated at 180°C for 2 hours to obtain a block copolymerized polyimide with a solid content of 38%. This block copolymerized polyimide has general formula (1): general formula (2) = 1: 1, a number average molecular weight of 50,000 and a weight average molecular weight of 100,000. Also, the weight average molecular weight of an imide oligomer block having a structural unit represented by the general formula (1) is 6,000. The solution of the block copolymerized polyimide resin is diluted with NMP into a block copolymerized polyimide resin solution with a solid content of 15% to thereby obtain a block copolymerized polyimide C.

### (Comparative Synthesis Example 1)

To a 2 L three-necked flask provided with an anchor shaped stirring stick of stainless steel and a reflux cooler equipped with a ball cooling tube mounted on a trap with a nitrogen introducing tube and a stopcock are added 164 g (400 mmol) of ethylene glycol bistrimerytate dianhydride, 124 g (400 mmol) of 4,4'-diamino-3,3',5,5'-tetraethyldiphenylmethane, 4.0 g (40 mmol) of γ-valerolactone, 4.8 g (60 mmol) of pyridine, 300g of NMP and 20 g of toluene, which are heated at 180°C for 3 hours to obtain a polyimide resin solution. This polyimide resin has a number average molecular weight of 31,000 and a weight average molecular weight of 78,000. The polyimide resin solution is further diluted with NMP into a polyimide resin solution with a solid content of 15% to thereby obtain a comparative polyimide A.

### (Comparative Synthesis Example 2)

To a 2 L three neck flask provided with an anchor shaped stirring stick of stainless steel and a reflux cooler equipped with a ball cooling tube mounted on a trap with a nitrogen introducing tube and a stopcock are added 147.1 g (500 mmol) of 3,4,3',4'-biphenyl tetracarboxylic dianhydride, 73.08 g (250 mmol) of 1,3-bis(3-aminophenoxy)benzene, 102.65 g (250 mmol) of 2,2-bis[4-(4-aminophenoxy)phenyl]propane, 4.0 g (40 mmol) of γ-valerolactone, 4.8 g (60 mmol) of pyridine, 500g of N-methyl-2-pyrolidone and 60 g of toluene, which are mixed at room temperature for 1 hour and then heated at 180°C for 3 hours to obtain a random copolymerized polyimide with a solid content of 38%. This random copolymerized polyimide has general formula (1): general formula (2) = 1: 1, a number average molecular weight of 50,000 and a weight average molecular weight of 100,000. The solution of the random copolymerized polyimide resin is diluted with NMP into a random copolymerized polyimide resin solution with a solid content of 15% to obtain a random copolymerized polyimide A.

### (Preparation Example of B-stage Resin Composition Layer)

400 g of 2,2-bis(4-cyanatophenyl)propane is melted at 150°C, reacted for 4 hours with stirring, dissolved in methyl ethyl ketone, returned to room temperature and subsequently added with 600 g of brominated bisphenol A type epoxy resin (Epiclon1123P, made by DIC Co., Ltd.), 500 g of finely powdery talc (SG-2000, made by Nippon Talc Co., Ltd. average particle size: about 1 µm) and 1.0 g of zinc octoate, which are stirred with a homomixer for 30 minutes to form a varnish. The ratio by volume of an inorganic filler contained in the solid content of this varnish is 17%. Also, the ratio by volume of the inorganic filler contained in total of the B-stage resin and the inorganic filler is 17%. This varnish is impregnated into a flat woven glass cloth of E-glass fibers having a mass of 48 g/m² per unit area, and dried at 150°C for 6 minutes to prepare a B-stage resin composition layer (prepreg A) with a gelation time at 170°C of 150 seconds.

### (Example 1)

50 parts of block copolymerized polyimide A, 50 parts of 2,2'-bis[4-(4-maleimidephenoxy)phenyl]propane as a maleimide compound and 60 parts of boehmite with an average particle size of 0.6 µm as an inorganic filler are stirred with a homomixer for 1 hour to obtain a varnish of block copolymerized polyimide. The ratio by volume of the inorganic filler contained in the solid content of the varnish is 18%. Also, the ratio by volume of the inorganic filler contained in total of the block copolymerized polyimide resin and the inorganic filler is 34%. The varnish of the block copolymerized polyimide is applied to a matte surface of an electrolytic copper foil with a thickness of 12 µm (F1-WS foil, matte surface roughness Rz = 1.9 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs A, and laminating them at a temperature of 220°C, a pressure of 40 kgf/cm² and a vacuum degree of not more than 30 mmHg for 1 hour. The evaluation results are shown in Table 1.

### (Example 2)

100 parts of block copolymerized polyimide B and 100 parts of boehmite with an average particle size of 0.6 µm as an inorganic filler are stirred with a homomixer for 1 hour to obtain a varnish of block copolymerized polyimide. The ratio by volume of the inorganic filler contained in the solid content of the varnish is 30%. The varnish of block copolymerized polyimide is applied to a matte surface of an electrolytic copper foil with a thickness of 12 µm (F2-WS foil, matte surface roughness Rz = 2.1 µm, made by Furukawa Circuit Foil Co., Ltd.) using a reverse roll coater, dried under a nitrogen atmosphere at 120°C for 3 minutes and at 160°C for 3 minutes, and finally heated at 260°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs A, and laminating them at a temperature of 220°C, a pressure of 40 kgf/cm² and a vacuum degree of not more than 30 mmHg for 1 hour. The evaluation results are shown in Table 1.

### (Example 3)

50 parts of the block copolymerized polyimide C prepared in Synthesis Example 3, 50 parts of 2,2'-bis[4-(4-maleimidephenoxy)phenyl]propane as a maleimide compound and 70 parts of boehmite with an average particle size of 0.6 µm as an inorganic filler are stirred with a homomixer for 1 hour to obtain a varnish of block copolymerized polyimide. The ratio by volume of the inorganic filler contained in the solid content of the varnish is 20%. Also, the ratio by volume of the inorganic filler contained in total of the block copolymerized polyimide resin and the inorganic filler is 38%. The varnish of block copolymerized polyimide is applied to a matte surface of an electrolytic copper foil with a thickness of 12 µm (F2-WS foil, matte surface roughness Rz = 2.0 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs (CN-71 made by Mitsubishi Gas Chemical Co., Ltd.), and laminating them at a temperature of 220°C, a pressure of 40 kgf/cm² and a vacuum degree of not more than 30 mmHg for 1 hour. The evaluation results are shown in Table 1.

### (Example 4)

50 parts of the block copolymerized polyimide C prepared in Synthesis Example 3, 50 parts of 2,2'-bis[4-(4-maleimidephenoxy)phenyl]propane as a maleimide compound and 70 parts of boehmite with an average particle size of 0.6 µm as an inorganic filler are stirred with a homomixer for 1 hour to obtain a varnish of block copolymerized polyimide. The ratio by volume of the inorganic filler contained in the solid content of the varnish is 20%. Also, the ratio by volume of the inorganic filler contained in total of the block copolymerized polyimide resin and the inorganic filler is 38%. The varnish of block copolymerized polyimide is applied to a matte surface of an electrolytic copper foil with a thickness of 12 µm (F1-WS foil, matte surface roughness Rz = 1.9 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs (CN-71 made by Mitsubishi Gas Chemical Co., Ltd.), and laminating them at a temperature of 220°C, a pressure of 40 kgf/cm² and a vacuum degree of not more than 30 mmHg for 1 hour. The evaluation results are shown in Table 1.

### (Comparative Example 1)

The block copolymerized polyimide A is applied to a matte surface of an electrolytic copper foil with a thickness of 12 µm (F2-WS foil, matte surface roughness Rz = 2.1 µm, made by Furukawa Circuit Foil Co., Ltd.) using a reverse roll coater, dried under a nitrogen atmosphere at 120°C for 3 minutes and at 160°C for 3 minutes, and finally heated at 260°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs A, and laminating them at a temperature of 220°C, a pressure of 40 kgf/cm² and a vacuum degree of not more than 30 mmHg for 1 hour. The evaluation results are shown in Table 1.

### (Comparative Example 2)

50 parts of the comparative polyimide A, 50 parts of 2,2'-bis[4-(4-maleimidephenoxy)phenyl]propane as a maleimide compound and 60 parts of boehmite with an average particle size of 0.6 µm as an inorganic filler are stirred with a homomixer for 1 hour to obtain a varnish of comparative polyimide. The ratio by volume of the inorganic filler contained in the solid content of the varnish is 18%. The varnish of the comparative polyimide is applied to a matte surface of an electrolytic copper foil with a thickness of 12 µm (F1-WS foil, matte surface roughness Rz = 1.9 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs A, and laminating them at a temperature of 220°C, a pressure of 40 kgf/cm² and a vacuum degree of not more than 30 mmHg for 1 hour. The evaluation results are shown in Table 1.

### (Comparative Example 3)

50 parts of the random copolymerized polyimide A prepared in Comparative Synthesis Example 2, 50 parts of 2,2'-bis[4-(4-maleimidephenoxy)phenyl]propane as a maleimide compound and 70 parts of boehmite with an average particle size of 0.6 µm as an inorganic filler are stirred with a homomixer for 1 hour to obtain a varnish of random copolymerize polyimide. The ratio by volume of the inorganic filler contained in the solid content of the varnish is 20%. The varnish of random copolymerized polyimide is applied to a matte surface of an electrolytic copper foil with a thickness of 12 µm (F2-WS foil, matte surface roughness Rz = 2.0 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs (CN-71 made by Mitsubishi Gas Chemical), and laminating them at a temperature of 220°C, a pressure of 40 kgf/cm² and a vacuum degree of not more than 30 mmHg for 1 hour. The evaluation results are shown in Table 1.

### (Comparative Example 4)

50 parts of the random copolymerized polyimide A prepared in Comparative Synthesis Example 2, 50 parts of 2,2'-bis[4-(4-maleimidephenoxy)phenyl]propane as a maleimide compound and 70 parts of boehmite with the average particle size of 0.6 µm as an inorganic filler are stirred with a homomixer for 1 hour to obtain a varnish of random copolymerize polyimide. The ratio by volume of the inorganic filler contained in the solid content of the varnish is 20%. The varnish of random copolymerized polyimide is applied to a matte surface of an electrolytic copper foil with a thickness of 12 µm (F1-WS foil, matte surface roughness Rz = 1.9 µm, made by Furukawa Circuit Foil Co., Ltd.) using a reverse roll coater, and dried under a nitrogen atmosphere at 120°C for 3 minutes and at 170°C for 3 minutes to prepare a resin composite copper foil. A copper-clad laminate of 0.1 mm in thickness is prepared by arranging resin layer surfaces of the above resin composite copper foils opposing upper and lower surfaces of two laminated prepregs (CN-71 made by Mitsubishi Gas Chemical Co., Ltd.), and laminating them at a temperature of 220°C, a pressure of 40 kgf/cm² and a vacuum degree of not more than 30 mmHg for 1 hour. The evaluation results are shown in Table 1.

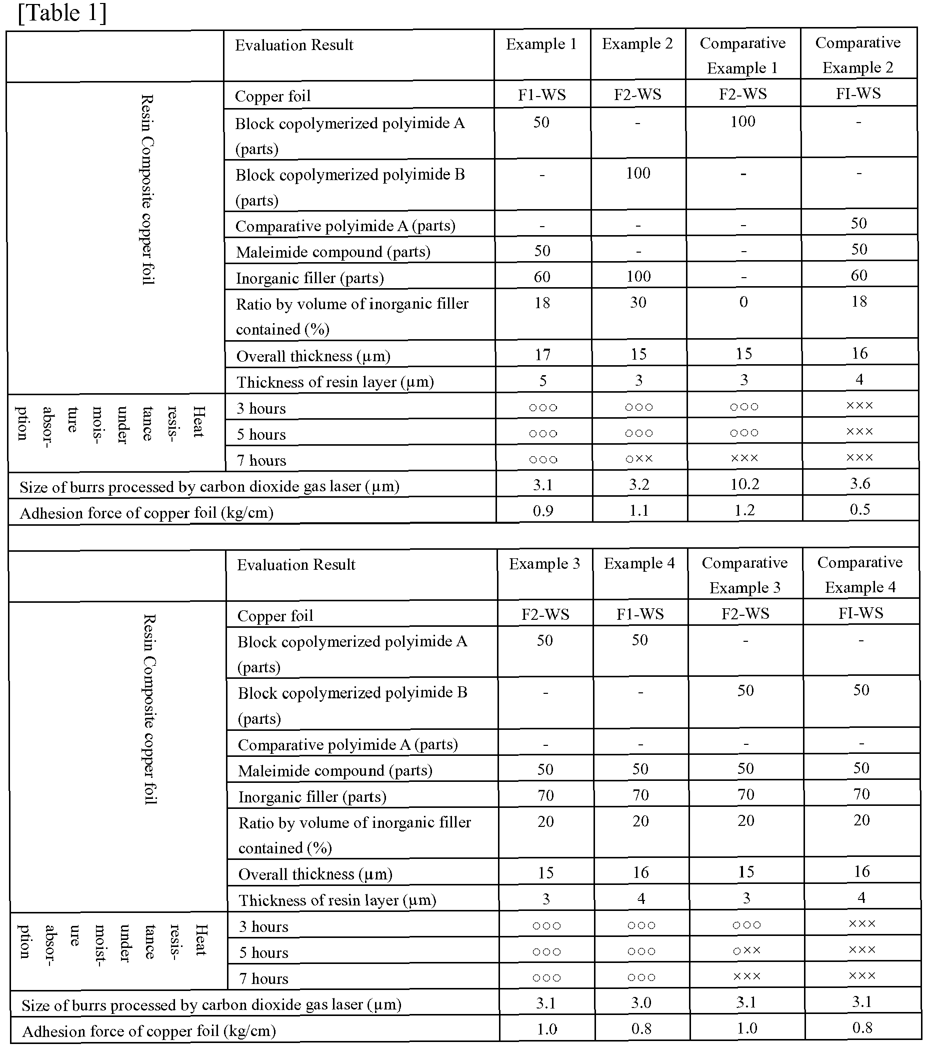

### (Measurement Method)

### 1) Overall thickness:

Average value of thicknesses at five points of the resin composite copper foil measured with a micrometer according to JIS C 6481.

### 2) Adhesion force of copper foil:

Average value of three measurements according to JIS C 6481.

### 3) Heat resistance under moisture absorption:

After an entire copper foil is removed from half of one surface of a sample with 50 mm × 50 mm square by etching, the sample is treated with a pressure cooker testing machine (PC-3 Model, made by Hirayama Manufacturing Corporation) at 121°C and 2 atmospheres for a predetermined time and then floated in a solder bath at 260°C for 60 seconds to visually observe the presence or absence of abnormality in appearance change. The test is conducted on three foils and the result is shown on each foil as ○ for one with no abnormality and × for one with swelling occurred.

### 4) Size of burrs processed by carbon dioxide gas laser:

Through-hole processing is conducted by laminating a laser sheet (LSE30) made by Mitsubishi Gas Chemical Co., Ltd. on the copper-clad board and radiating 20 mJ/1 shot, 30 mJ/1 shot and 10mJ/3 shots of processing energy in a cycle mode with a carbon dioxide gas laser processing machine (YB-HCS03) made by Panasonic Welding Systems Co., Ltd. at a mask diameter of 2.0 mm. After the laser sheet is peeled off, the board is subjected to a desmear treatment (OPC-B103, OPC-1200, OPC-1540 MN, OPC-1300 made by Okuno Chemical Industries: swelling treatment 65°C/5 minutes, etching treatment 80°C/8 minutes, neutralization treatment 45°C/5 minutes), and etched with a mixed liquid of hydrogen peroxide and sulfuric acid so as to render a thickness of an outer layer copper foil into 5 ± 1 µm. Then, about 15 µm of copper plating is attached through electroless copper plating and electrolytic copper plating to observe the cross section of the through-hole. As shown in FIG. 1, the size of burrs generated in the resin part of the resin composite copper foil is measured on an incident side of carbon dioxide gas laser and an opposite side (output side) thereof. The measurement is conducted on 10 holes to measure integrated value of burr sizes on the both left and right sides (total 20 places), from which the average value of the burr size per one place is calculated.

### 5) Molecular weight:

The molecular weight as converted to polystyrene is measured through GPC (gel permeation chromatography) using N-methyl-2-pyrrolidon (NMP) as a solvent.
Device name: HLC-8220GPC made by Tosoh Corporation
Name of column used: TSKgel SuperAWM-H made by Tosoh Corporation
Eluent: 10 mmol/L of N-methyl-2-pyrrolidone containing lithium bromide
Molecular weight standard: polystyrene

As shown in Table 1, the copper-clad laminates of Examples 1 to 4 are good in the heat resistance under moisture absorption, small in the burr size, and high in the adhesion force of copper foil. On the other hand, the copper-clad laminate of Comparative Example 1 using the resin composite copper foil containing no inorganic filler in the polyimide resin layer is large in the burr size. Also, the copper-clad laminate of Comparative Example 2 using the comparative polyimide is poor in the heat resistance under moisture absorption and low in the adhesion force of copper foil. Moreover, the copper-clad laminates of Comparative Examples 3 and 4 using the random copolymerized polyimide are poor in the heat resistance under moisture absorption.

## Claims

1. A resin composite copper foil comprising a copper foil and a polyimide resin layer formed on one surface of the copper foil,
wherein the polyimide resin layer comprises a block copolymerized polyimide resin and an inorganic filler, and
the block copolymerized polyimide resin has a structure formed by alternately repeating a structure A and a structure B,
wherein the structure A is obtained by bonding a second imide oligomer to a terminal of a first imide oligomer and the structure B is obtained by bonding the first imide oligomer to a terminal of the second imide oligomer, and
the block copolymerized polyimide resin is a block copolymer comprising the first imide oligomer represented by the following general formula (1) and the second imide oligomer represented by the following general formula (2): 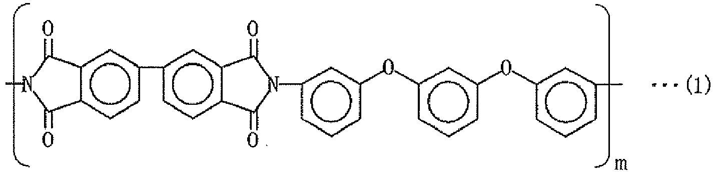 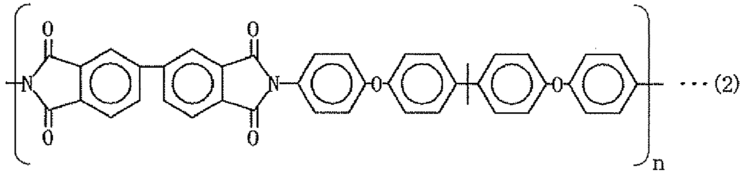 wherein m and n are integers meeting m:n=1:9 to 3:1).

2. A resin composite copper foil according to claim 1, wherein an amount of the inorganic filler contained in the polyimide resin layer is not less than 5% by volume but not more than 50% by volume based on 100% by volume in total of the block copolymerized polyimide resin and the inorganic filler, and a weight average molecular weight of the first imide oligomer is 5,000 to 30,000.

3. A resin composite copper foil according to claim 1 or 2, wherein the polyimide resin layer includes a maleimide compound.

4. A resin composite copper foil according to any one of claims 1 to 3, wherein the polyimide resin layer has a thickness of 1µm to 10µm.

5. A resin composite copper foil according to any one of claims 1 to 4, wherein the copper foil has a surface roughness (Rz) of not more than 4µm on a surface of forming the polyimide resin layer.

6. A copper-clad laminate formed by laminating a resin composite copper foil as claimed in any one of claims 1 to 5 and a B-stage resin composition layer.

7. A printed wiring board using a resin composite copper foil as claimed in any one of claims 1 to 5.

8. A printed wiring board using a copper clad laminate according to claim 6.

9. A copper clad laminate according to claim 6, wherein the B-stage resin composition layer contains a resin and an inorganic filler, and an amount of the inorganic filler contained is not less than 5% by volume but not more than 50% by volume based on 100% by volume in total of the resin and the inorganic filler.

10. A printed wiring board according to claim 8, wherein the B-stage resin composition layer contains a resin and an inorganic filler, and an amount of the inorganic filler contained is not less than 5% by volume but not more than 50% by volume based on 100% by volume in total of the resin and the inorganic filler.

## Patentansprüche

1. Eine Harzverbund-Kupferfolie, die eine Kupferfolie und eine auf einer Oberfläche der Kupferfolie gebildete Polyimidharzschicht beinhaltet,
wobei die Polyimidharzschicht ein blockcopolymerisiertes Polyimidharz und einen anorganischen Füllstoff beinhaltet und
das blockcopolymerisierte Polyimidharz eine durch abwechselndes Wiederholen einer Struktur A und einer Struktur B gebildete Struktur aufweist,
wobei die Struktur A durch das Binden eines zweiten Imid-Oligomers an ein Ende eines ersten Imid-Oligomers erhalten wird und die Struktur B durch das Binden des ersten Imid-Oligomers an ein Ende des zweiten Imid-Oligomers erhalten wird und
das blockcopolymerisierte Polyimidharz ein Blockcopolymer ist, welches das durch die folgende allgemeine Formel (1) dargestellte erste Imid-Oligomer und das durch die folgende allgemeine Formel (2) dargestellte zweite Imid-Oligomer beinhaltet: 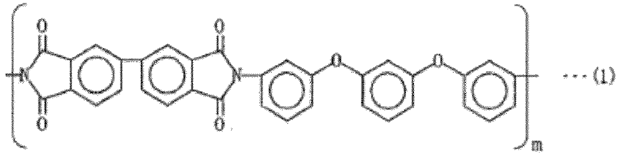 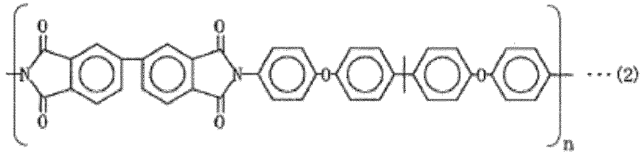 wobei m und n ganze Zahlen sind, die Folgendes erfüllen: m : n = 1 : 9 bis 3 : 1.

2. Harzverbund-Kupferfolie gemäß Anspruch 1, wobei eine Menge des in der Polyimidharzschicht enthaltenen anorganischen Füllstoffs nicht weniger als 5 Volumen-%, aber nicht mehr als 50 Volumen-%, bezogen auf insgesamt 100 Volumen-% des blockcopolymerisierten Polyimidharzes und des anorganischen Füllstoffs, beträgt und ein gewichtsmittleres Molekulargewicht des ersten Imid-Oligomers 5 000 bis 30 000 beträgt.

3. Harzverbund-Kupferfolie gemäß Anspruch 1 oder 2, wobei die Polyimidharzschicht eine Maleimidverbindung umfasst.

4. Harzverbund-Kupferfolie gemäß einem der Ansprüche 1 bis 3, wobei die Polyimidharzschicht eine Dicke von 1 µm bis 10 µm aufweist.

5. Harzverbund-Kupferfolie gemäß einem der Ansprüche 1 bis 4, wobei die Kupferfolie eine Oberflächenrauheit (Rz) von nicht mehr als 4 µm auf einer Oberfläche des Bildens der Polyimidharzschicht aufweist.

6. Ein kupferkaschiertes Laminat, gebildet durch das Laminieren einer Harzverbund-Kupferfolie gemäß einem der Ansprüche 1 bis 5 und einer B-Stufen-Harzzusammensetzungsschicht.

7. Eine Leiterplatte, die eine Harzverbund-Kupferfolie gemäß einem der Ansprüche 1 bis 5 verwendet.

8. Eine Leiterplatte, die ein kupferkaschiertes Laminat gemäß Anspruch 6 verwendet.

9. Kupferkaschiertes Laminat gemäß Anspruch 6, wobei die B-Stufen-Harzzusammensetzungsschicht ein Harz und einen anorganischen Füllstoff enthält und eine Menge des enthaltenen anorganischen Füllstoffs nicht weniger als 5 Volumen-%, aber nicht mehr als 50 Volumen-%, bezogen auf insgesamt 100 Volumen-% des Harzes und des anorganischen Füllstoffs, beträgt.

10. Leiterplatte gemäß Anspruch 8, wobei die B-Stufen-Harzzusammensetzungsschicht ein Harz und einen anorganischen Füllstoff enthält und eine Menge des enthaltenen anorganischen Füllstoffs nicht weniger als 5 Volumen-%, aber nicht mehr als 50 Volumen-%, bezogen auf insgesamt 100 Volumen-% des Harzes und des anorganischen Füllstoffs, beträgt.

## Revendications

1. Une feuille de cuivre composite à base de résine comprenant une feuille de cuivre et une couche de résine polyimide formée sur une surface de la feuille de cuivre,
dans laquelle la couche de résine polyimide comprend une résine polyimide copolymérisée en blocs et une charge inorganique, et
la résine polyimide copolymérisée en blocs a une structure formée en répétant en alternance une structure A et une structure B,
dans laquelle la structure A est obtenue en liant un deuxième oligomère imide à une partie terminale d'un premier oligomère imide et la structure B est obtenue en liant le premier oligomère imide à une partie terminale du deuxième oligomère imide, et
la résine polyimide copolymérisée en blocs est un copolymère à blocs comprenant le premier oligomère imide représenté par la formule générale suivante (1) et le deuxième oligomère imide représenté par la formule générale suivante (2) : 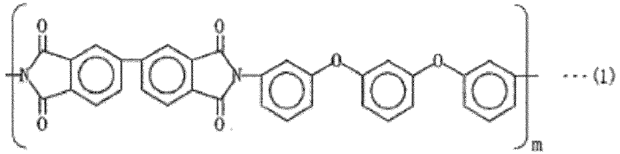 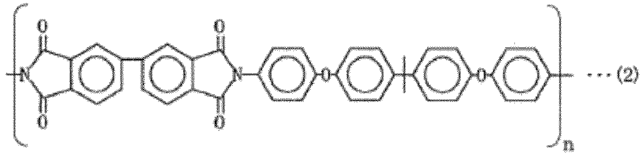 dans lesquelles m et n sont des nombres entiers satisfaisant à m/n = 1/9 à 3/1.

2. Une feuille de cuivre composite à base de résine selon la revendication 1, dans laquelle une quantité de la charge inorganique contenue dans la couche de résine polyimide n'est pas inférieure à 5 % en volume mais n'est pas supérieure à 50 % en volume rapporté à 100 % en volume, au total, de la résine polyimide copolymérisée en blocs et de la charge inorganique, et une masse moléculaire moyenne en poids du premier oligomère imide va de 5 000 à 30 000.

3. Une feuille de cuivre composite à base de résine selon la revendication 1 ou la revendication 2, dans laquelle la couche de résine polyimide inclut un composé maléimide.

4. Une feuille de cuivre composite à base de résine selon n'importe laquelle des revendications 1 à 3, dans laquelle la couche de résine polyimide a une épaisseur de 1 µm à 10 µm.

5. Une feuille de cuivre composite à base de résine selon n'importe laquelle des revendications 1 à 4, la feuille de cuivre ayant une rugosité de surface (Rz) qui n'est pas supérieure à 4 µm sur une surface de formation de la couche de résine polyimide.

6. Un stratifié revêtu de cuivre formé par stratification d'une feuille de cuivre composite à base de résine telle que revendiquée dans n'importe laquelle des revendications 1 à 5 et d'une couche de composition de résine au stade B.

7. Une carte de circuits imprimés utilisant une feuille de cuivre composite à base de résine telle que revendiquée dans n'importe laquelle des revendications 1 à 5.

8. Une carte de circuits imprimés utilisant un stratifié revêtu de cuivre selon la revendication 6.

9. Un stratifié revêtu de cuivre selon la revendication 6, dans lequel la couche de composition de résine au stade B contient une résine et une charge inorganique, et une quantité de la charge inorganique contenue n'est pas inférieure à 5 % en volume mais n'est pas supérieure à 50 % en volume rapporté à 100 % en volume, au total, de la résine et de la charge inorganique.

10. Une carte de circuits imprimés selon la revendication 8, dans laquelle la couche de composition de résine au stade B contient une résine et une charge inorganique, et une quantité de la charge inorganique contenue n'est pas inférieure à 5 % en volume mais n'est pas supérieure à 50 % en volume rapporté à 100 % en volume, au total, de la résine et de la charge inorganique.
